Europäisches Patentamt

**European Patent Office**

**Office européen des brevets**

(19)

(11) Veröffentlichungsnummer: **0 011 879**
**B1**

(12) **EUROPÄISCHE PATENTSCHRIFT**

(45) Veröffentlichungstag der Patentschrift:
29.12.82

(21) Anmeldenummer: **79104854.9**

(22) Anmeldetag: **03.12.79**

(51) Int. Cl.³: **H 01 L 29/78,** H 01 L 29/36,
H 01 L 29/10

(54) **Feldeffekttransistor.**

(30) Priorität: **05.12.78 DE 2852621**

(43) Veröffentlichungstag der Anmeldung:
**11.06.80 Patentblatt 80/12**

(45) Bekanntmachung des Hinweises auf die Patenterteilung:
**29.12.82 Patentblatt 82/52**

(84) Benannte Vertragsstaaten:
**CH FR GB IT**

(56) Entgegenhaltungen:
**DE-B-1 489 055**
**DE-C-1 066 667**
**SOLID STATE ELECTRONICS, Band 16, Heft 4,**
**1973 Oxford G. R. MOHAN RAO et al. »Mosfet**
**devices with trapezoidal gates: I-V characteristics**
**and magnetic sensitivity« Seiten 483 bis 490**
**IBM TECHNICAL DISCLOSURE BULLETIN, Band**
**21, Heft 9, Februar 1979 New York T. DEVINE et al.**
**»FET driver layout having small interconnected**
**drain regions« Seiten 3670 bis 3671**

(73) Patentinhaber: **SIEMENS AKTIENGESELLSCHAFT**
**Berlin und München, Postfach 22 02 61,**
**D-8000 München 22 (DE)**

(72) Erfinder: **Jenö, Tihanyi, Dr. Dipl.-Phys., Wolfratshauser**
**Strasse 179b, D-8000 München 71 (DE)**

Feldeffekttransistor

Die vorliegende Erfindung bezieht sich auf einen Feldeffekttransistor mit einem Halbleitersubstrat vom ersten Leitungstyp, einer Sourcezone und einer Drainzone vom entgegengesetzten Leitungstyp, mit einer zwischen der Source- und Drainzone liegenden Zone des entgegengesetzten Leitungstyps, die schwächer dotiert ist als die Source- und Drainzone und die von einem Bereich umgeben ist, der vom ersten Leitungstyp und höher dotiert ist als das Substrat, mit einer gegen die Oberfläche des Halbleitersubstrats isolierten Gateelektrode, die die genannte Zone auf ihrer gesamten Breite überdeckt, wobei der zwischen der Gateelektrode und der Drainzone liegende Teil der genannten Zone eine Driftstrecke für die Ladungsträger bildet.

Ein solcher Feldeffekttransistor ist zum Beispiel in der DE-A-2 706 623 bereits beschrieben worden. Feldeffekttransistoren dieser Art sind im allgemeinen für Betriebsspannungen von 50 bis 100 Volt ausgelegt. Der Einsatz bei höheren Betriebsspannungen scheiterte bisher daran, daß die Feldstärke im stromführenden Kanal zwischen Gateelektrode und Drainzone so hoch wurde, daß ein Lawinendurchbruch auftrat.

Einer Erhöhung der Feldstärke zwischen Gateelektrode und Drainzone auf einen kritischen Wert, bei dem der Lawinendurchbruch einsetzt, hat man dadurch entgegenzuwirken versucht, daß über dem stromführenden Kanal von der Gateelektrode zur Drainzone hin in wachsendem Abstand zur Oberfläche des Substrats eine oder mehrere Hilfselektroden angeordnet wurden. Das bedingt einen abgestuften Aufbau der auf dem Substrat angebrachten Isolierschicht sowie das Anlegen von Hilfsspannungen an die Hilfselektroden.

Der Erfindung liegt die Aufgabe zugrunde, einen Feldeffekttransistor gemäß der eingangs genannten Art so weiterzubilden, daß er bei höheren Betriebsspannungen einsetzbar ist, ohne daß Hilfselektroden und Hilfsspannungsquellen erforderlich sind. Der Feldeffekttransistor soll außerdem eine ohne großen Aufwand integrierbare Struktur aufweisen.

Die Erfindung ist dadurch gekennzeichnet, daß der Querschnitt der Driftstrecke senkrecht zur Driftrichtung ausgehend von der Gateelektrode in Richtung zur Drainzone eine zunehmende Anzahl von Dotierstoffatomen enthält.

Die wichtigste Ausgestaltung dieses Prinzips besteht darin, daß die Driftstrecke eine im wesentlichen konstante Dotierung aufweist und daß sich die Driftstrecke von der Gateelektrode zur Drainzone auf einen Wert verbreitert, der gleich dem Mehrfachen der Breite der Drainzone ist. Dies kann vorteilhafterweise entweder dadurch erreicht werden, daß die Gateelektrode streifenförmig ausgebildet ist und sich die genannte Zone zur Drainzone hin erweitert oder daß die genannte Zone eine konstante Breite hat und daß die Gateelektrode mit einer sich zur Drainzone hin erweiternden Aussparung versehen ist.

Weitere Ausgestaltungen der Erfindung sind Gegenstand der Unteransprüche.

Die Erfindung wird an Hand einiger Ausführungsbeispiele in Verbindung mit den Fig. 1 bis 6 näher erläutert. Es zeigen:

Fig. 1 und 2 einander entsprechende Ansichten einer ersten Ausführungsform, bei der sich die genannte Zone zur Drainzone hin verbreitert,

Fig. 3 die Aufsicht auf ein weiteres Ausführungsbeispiel, bei der die genannte Zone konstante Breite hat und die Erweiterung der Driftstrecke durch eine sich zur Drainzone hin erweiternde Aussparung der Gateelektrode gebildet ist,

Fig. 4 die Aufsicht auf eine Mehrfachanordnung unter Verwendung des Prinzips nach Fig. 3,

Fig. 5 die Aufsicht auf eine Weiterbildung der Anordnung nach Fig. 4 und

Fig. 6 eine Mehrfachanordnung unter Verwendung des Prinzips nach den Fig. 1, 2.

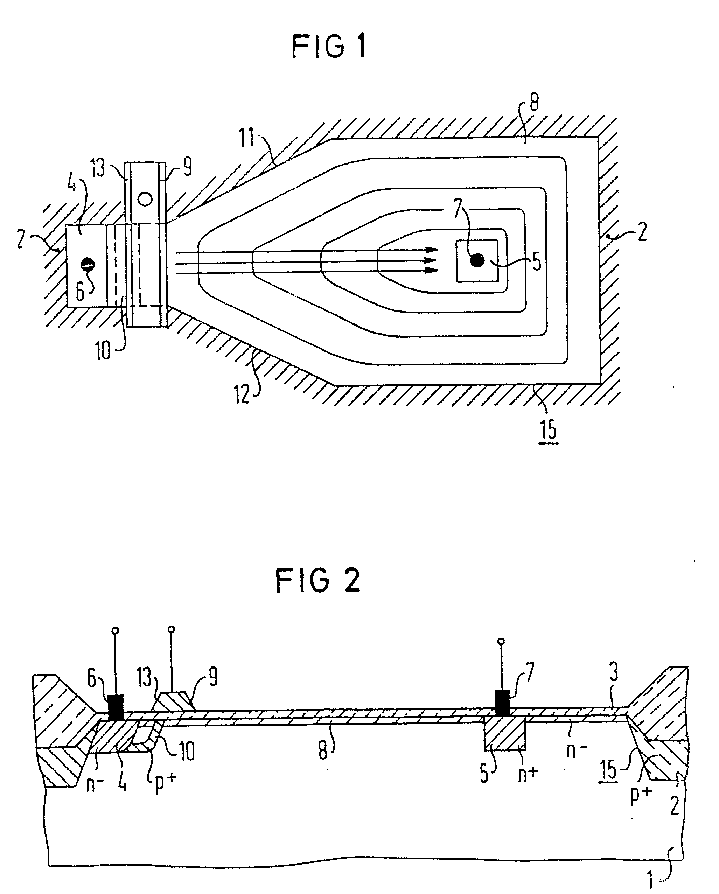

In den Fig. 1, 2 sind die Aufsicht und der Schnitt durch einen Feldeffekttransistor (FET) für höhere Betriebsspannungen dargestellt. Der FET weist ein Substrat 1 auf, das zum Beispiel aus schwach p-dotiertem Silicium besteht. Der FET wird durch eine stark p-dotierte Zone 2 begrenzt, die in Fig. 1 der besseren Übersichtlichkeit halber schraffiert dargestellt ist und sich nach außen fortsetzt. Im Substrat 1 ist eine Sourcezone 4 und eine Drainzone 5 mit starker n-Leitfähigkeit angeordnet. Zwischen der Sourcezone 4 und der Drainzone 5 liegt eine, schwach n-dotierte Zone 8. Die Oberfläche des Halbleitersubstrats wird von einer aus Siliciumdioxid bestehenden Isolierschicht 3 bedeckt. In der Nähe der Sourcezone 4 ist auf der Isolierschicht 3 eine Gateelektrode 9 angeordnet, die aus polykristallinem Silicium bestehen kann. In Fig. 1 und allen anderen Aufsichten wurde die Isolierschicht 3 der besseren Übersichtlichkeit halber weggelassen.

Die schwach n-dotierte Zone 8 ist in der Nähe der Sourcezone 4 durch eine stark p-dotierte Zone 10 unterbrochen. Die Zone 10 und die Sourcezone 4 wird durch Doppelionenimplantation hergestellt. Für eine solche Struktur wird daher auch die Bezeichnung »DIMOS-FET« verwendet. Die Gateelektrode 9 dient dabei als Maske und weist dazu eine schräge Flanke 13 auf, wodurch die Zone 10 den dargestellten schräg abfallenden Verlauf erhält, um in einer durch die Größe der implantierten Ionen und deren Energie bestimmten Tiefe des Substrats 1 einen waagrechten Verlauf anzunehmen. Für die Funktion des FET ist diese Zone 10 nicht unbedingt erforderlich, wenn man auf eine vollständige Sperrung des zwischen Sourcezone 4 und Drainzone 5 liegenden stromführenden Kanals verzichtet. Der FET kann dann als steuerbarer Widerstand in einem Komplex von integrierten Halbleiterbauelementen Anwendung finden.

Die Zone 8 bildet zwischen der Gateelektrode 9 und der Drainzone 5 eine Driftstrecke für die von der Sourcezone 4 ausgehenden Elektronen. Die Driftstrecke 8 erweitert sich von der Gateelektrode 9 ausgehend auf eine Breite, die um ein Mehrfaches größer als die Breite der Drainzone 5 ist. Die Driftstrecke 8 wird dabei von einem pn-Übergang 15 begrenzt. Der sich verbreiternde Teil der Driftstrecke 8 wird durch Kanten 11, 12 des pn-Übergangs 15 begrenzt, die miteinander einen Winkel zwischen 30 und 90° einschließen. Der Abstand von der Gateelektrode 9 zur Drainzone 5 kann zum Beispiel 5 bis 100 μm, die größte Breite der Driftstrecke 8 10 bis 100 μm betragen. Der Winkel kann sich auch in einem weiteren Bereich zwischen 20° und <180° bewegen. Als besonders günstig haben sich folgende Abmessungen herausgestellt: Abstand 50 μm, größte Breite 30 μm, Winkel 45°, Breite der Zone 8 unter der Gateelektrode 5 μm. Die Gateelektrode kann 2 bis 10 μm breit sein.

Wird an die Elektroden 6 und 7 eine Spannung angelegt, so beginnt abhängig von der Größe der an die Gateelektrode 9 gelegten Steuerspannung ein Strom von der Sourcezone 4 zur Drainzone 5 zu fließen. Entsprechend der Größe der zwischen den Elektroden 6 und 7 angelegten Spannung bilden sich Äquipotentiallinien aus, die die in Fig. 1 gezeigte Form aufweisen. Die Ladungsträger nehmen dabei den durch die Pfeile angedeuteten Verlauf zur Drainzone 5. Es ist ersichtlich, daß die Äquipotentiallinien im Bereich des durch den Pfeil angedeuteten stromführenden Kanals den größten Abstand haben. Dies bedeutet, daß hier die Feldstärke am geringsten ist und die Gefahr eines Lawinendurchbruchs entsprechend herabgesetzt wird. Durch die Verbreiterung der Driftstrecke 8 vermindert sich auch die Feldstärke in allen übrigen Bereichen zwischen der stark dotierten Zone 2 und der Drainzone 5.

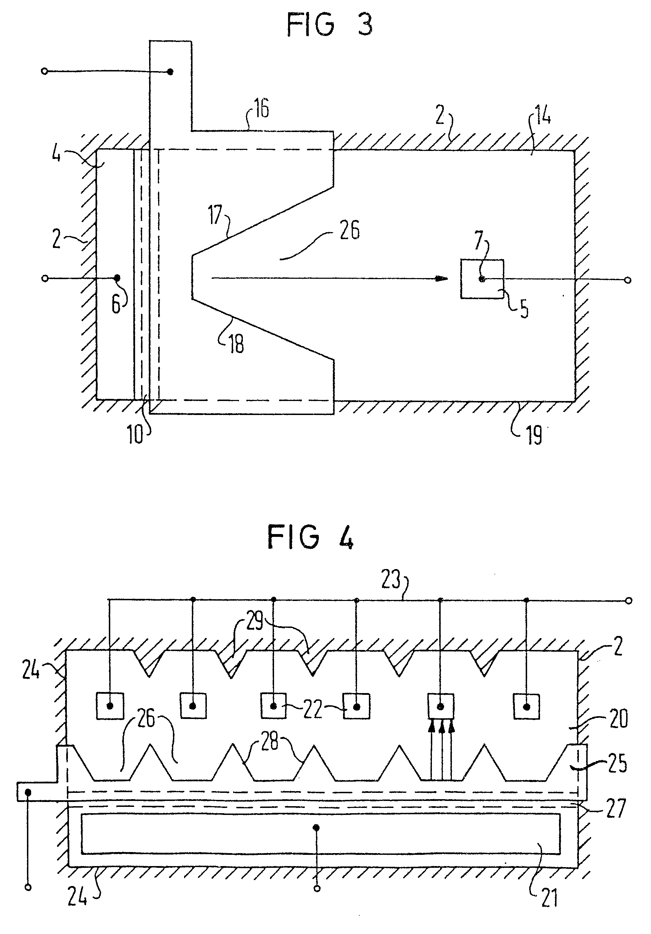

Die Anordnung nach Fig. 3 hat eine schwach n-dotierte Zone 14 mit konstanter Breite. Sie wird durch den pn-Übergang 19 begrenzt. Die Sourcezone 4 ist so breit wie die Zone 14. Die Gateelektrode 16 weist eine zur Drainzone sich verbreiternde Aussparung 26 auf, deren seitliche Kanten mit 17, 18 bezeichnet sind. Diese Kanten schließen miteinander einen Winkel zwischen 30 und 90° ein. Die Kanten 17, 18 legen den Verlauf der Äquipotentiallinien fest, die damit eine Gestalt wie in Fig. 1 bekommen. Auch bei diesem FET ist daher eine Driftstrecke vorhanden, die sich von der Gateelektrode zur Drainzone auf einen Wert verbreitert, der gleich dem Mehrfachen der Breite der Drainzone ist. Auch diese Driftstrecke enthält somit von der Gateelektrode in Richtung zur Drainzone hin eine zunehmende Anzahl von Dotierstoffatomen, und eine Absenkung der Feldstärke zwischen Gateelektrode 16 beziehungsweise der Zone 2 und der Drainzone 5 wird erzielt.

In Fig. 4 ist ein sich aus Vervielfältigung des FET nach Fig. 3 ergebender integrierter FET dargestellt. Er weist mehrere Drainzonen 22 auf, die über eine gemeinsame Leitung 23 elektrisch miteinander verbunden sind. Die Driftstrecken dieses FET bilden einen gemeinsamen Driftbereich 20, der ebenso wie in den vorhergehenden Ausführungsbeispielen schwach n-dotiert sein kann. Die Sourcezone 21 ist streifenförmig ausgeführt und liegt allen Drainzonen 22 gegenüber. Entsprechendes gilt für die die schwach n-dotierte Zone unterbrechende stark p-dotierte Zone 27. Die Gateelektrode überdeckt die gesamte Breite des Driftbereichs 20 und ist mit einer der Anzahl der Drainzonen 22 entsprechenden Anzahl von Aussparungen 26 versehen. Die Aussparungen 26 liegen den einzelnen Drainzonen 22 gegenüber. Die Aussparungen sind durch Kanten 28 begrenzt, die wie bereits oben erwähnt miteinander einen Winkel zwischen 30 und 90° einschließen. Der Driftbereich 20 wird von einem pn-Übergang 24 umschlossen. Der pn-Übergang 24 kann auf der der Gateelektrode 25 abgelegenen Seite der Drainzonen 22 mit Vorsprüngen 29 versehen sein, die jeweils zwischen zwei der Drainzonen liegen. Diese Vorsprünge 29 beeinflussen den Verlauf der Äquipotentiallinien hinter den Drainzonen. Sie können so ausgebildet sein, daß der Raum zwischen zwei dieser Vorsprünge im Bereich 20 etwa den Aussparungen 26 der Gateelektrode 25 entspricht.

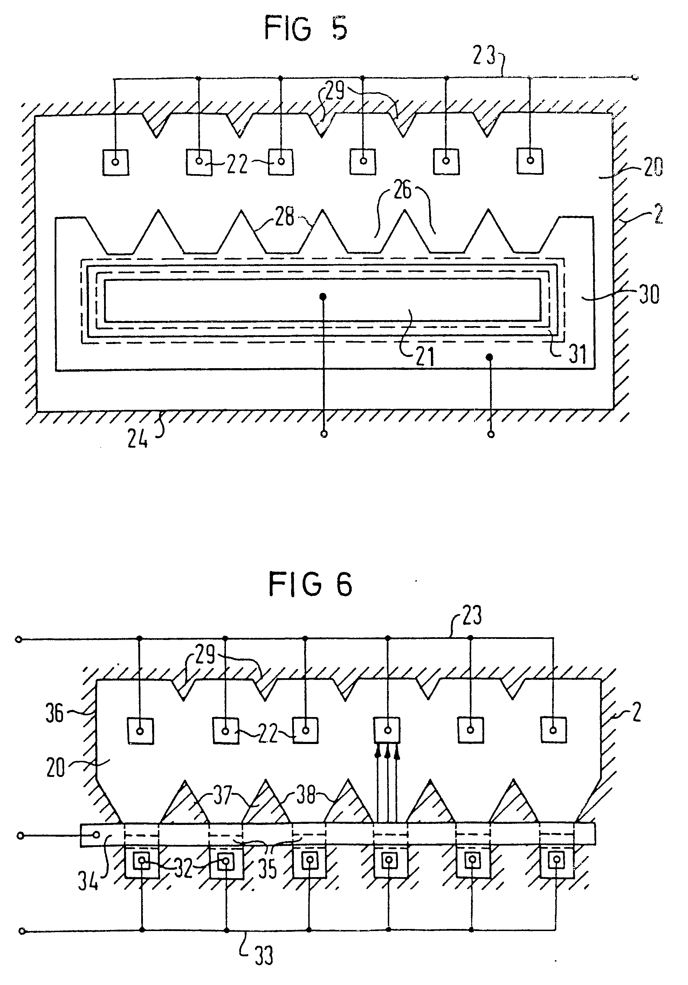

Der FET nach Fig. 5 unterscheidet sich von dem nach Fig. 4 im wesentlichen dadurch, daß die den schwach n-leitenden Bereich unterbrechende stark p-dotierte Zone 31 (27 in Fig. 4) und die Gateelektrode 30 die Sourcezone 21 allseitig umschließt. Diese Ausführungsform wird vorzugsweise dann verwendet, wenn zwischen Sourcezone 21 und Gateelektrode 30 eine höhere Spannung angelegt werden soll.

In Fig. 6 ist ein integrierter FET dargestellt, der aus einer Vielzahl von Strukturen nach Fig. 1 und 2 besteht. Dieser FET weist eine Vielzahl von Sourcezonen 32 auf, die über eine gemeinsame Leitung 33 elektrisch miteinander verbunden sind. Zwischen den Sourcezonen 32 und dem Driftbereich 20 ist eine Vielzahl von stark p-dotierten weiteren Zonen 35 angeordnet, die in ihrer Funktion der Zone 10 in Fig. 1 entsprechen. Zwischen den Sourcezonen 32 und dem Driftbereich 20 liegt eine streifenförmige Gateelektrode 34. Der gemeinsame Bereich 20 ist von einem pn-Übergang 36 umgeben, der auch die Sourcezonen 32 umschließt. Der pn-Übergang 36 weist Vorsprünge 37 auf, die zwischen jeweils zwei der Sourcezonen 32 liegen und sich in Richtung auf die Drainzonen erweiternde Driftstrecken für die Ladungsträger bilden. Die Vorsprünge 37 sind durch Kanten 38 begrenzt, die den Kanten 11 und 12 in Fig. 1 entsprechen.

Für die Abmessungen der einzelnen Driftstrecken gilt das in Verbindung mit den Fig. 1 und 2 Gesagte. Damit lassen sich für einen der integrierten FET-Strukturen nach Fig. 4, 5 oder 6 Stromstärken von beispielsweise 10 mA bei Spannungen von 100 bis 200 V erreichen.

In den erläuterten Beispielen wurde dargestellt, daß sich die Driftstrecken in Richtung auf die Drainzone beziehungsweise die Drainzonen hin erweitern. Dies bedeutet eine Zunahme von Dotierstoffatomen in Richtung zur Drainzone beziehungsweise den Drainzonen hin mit der günstigen Folge, daß die Feldstärke zwischen Gateelektrode und Drainzone beziehungsweise zwischen stark p-dotierter Zone und Drainzone vermindert wird. Es ist jedoch auch möglich, der Driftstrecke eine konstante Breite zu geben und sie in Richtung auf die Drainzone zu mit stetig oder schrittweise anwachsender Dotierungskonzentration zu versehen. Damit stehen auf der gesamten Länge des stromführenden Kanals genügend Ladungsträger zur Verfügung, um ein Anwachsen der Feldstärke auf einen zum Einsetzen eines Lawinendurchbruchs gefährlichen Wert zu verhindern. Es wäre an sich auch möglich, der Driftstrecke dadurch eine in Richtung zur Drainzone zunehmende Anzahl von Dotierstoffatomen zu geben, daß ihre Dicke zwischen Gateelektrode und Drainzone zunimmt. Eine Technologie zur Herstellung einer solchen Driftstrecke ist bis jetzt jedoch noch nicht in Sicht.

## Patentansprüche

1. Feldeffekttransistor mit einem Halbleitersubstrat (1) vom ersten Leitungstyp, einer Sourcezone (4) und einer Drainzone (5) vom entgegengesetzten Leitungstyp, mit einer zwischen der Source- und Drainzone liegenden Zone (8, 14) des entgegengesetzten Leitungstyps, die schwächer dotiert ist als die Source- und Drainzone und die von einem Bereich (2) umgeben ist, der vom ersten Leitungstyp und höher dotiert ist als das Substrat (1), mit einer gegen die Oberfläche des Halbleitersubstrats isolierten Gateelektrode (9, 16), die die genannte Zone (8, 14) auf ihrer gesamten Breite überdeckt, wobei der zwischen der Gateelektrode (9, 16) und der Drainzone (5) liegende Teil der genannten Zone (8, 14) eine Driftstrecke für die Ladungsträger bildet, dadurch gekennzeichnet, daß der Querschnitt der Driftstrecke (8, 14) senkrecht zur Driftrichtung ausgehend von der Gateelektrode (9, 16) in Richtung zur Drainzone (5) eine zunehmende Anzahl von Dotierstoffatomen enthält.

2. Feldeffekttransistor nach Anspruch 1, dadurch gekennzeichnet, daß die Driftstrecke (8, 14) eine im wesentlichen konstante Dotierung aufweist und ihre Breite sich von der Gateelektrode (9, 16) zur Drainzone (5) hin auf einen Wert verbreitert, der gleich dem Mehrfachen der Breite der Drainzone (5) ist.

3. Feldeffekttransistor nach Anspruch 2, dadurch gekennzeichnet, daß die Gateelektrode (9) streifenförmig ausgebildet ist und sich die genannte Zone (8) zur Drainzone (5) hin erweitert (Fig. 1).

4. Feldeffekttransistor nach Anspruch 2, dadurch gekennzeichnet, daß die genannte Zone (14) eine konstante Breite hat und daß die Gateelektrode (16) mit einer sich zur Drainzone (5) hin erweiternden Aussparung (26) versehen ist.

5. Feldeffekttransistor nach einem der Ansprüche 2 bis 4, dadurch gekennzeichnet, daß sich die Driftstrecke (8, 14) trichterförmig erweitert und daß der Öffnungswinkel zwischen 20° und < 180° liegt.

6. Feldeffekttransistor nach einem der Ansprüche 1 bis 5, gekennzeichnet durch eine die genannte Zone unterbrechende, von der Gateelektrode (9, 16, 25, 30, 34) mindestens teilweise überdeckte weitere Zone (10, 27, 31, 35) vom ersten Leitungstyp mit mindestens gleich hoher Dotierungskonzentration wie das Substrat (1).

7. Feldeffekttransistor nach einem der Ansprüche 4 bis 6, gekennzeichnet durch eine Vielzahl in der genannten Zone angeordneter, nebeneinanderliegender, elektrisch miteinander verbundener Source- (32) und Drainzonen (22), durch einen aus den einzelnen Driftstrecken einander gegenüberliegender Source- und Drainzonen gebildeten allen Source- und Drainzonen gemeinsamen Driftbereich (20), sowie durch eine gemeinsame an alle Driftstrecken angrenzende Gateelektrode (34) (Fig. 6).

8. Feldeffekttransistor nach Anspruch 7, gekennzeichnet durch eine streifenförmige, allen Drainzonen (22) gemeinsame Sourcezone (21), durch eine allen Drainzonen (22) gemeinsame weitere Zone (27) und durch eine Gateelektrode (25), die mit einer der Anzahl der Drainzonen (22) entsprechenden Anzahl von den Drainzonen gegenüberliegenden Aussparungen (26) versehen ist (Fig. 4).

9. Feldeffekttransistor nach Anspruch 8, gekennzeichnet durch eine die Sourcezone (21) umschließende weitere Zone (31) und durch eine die Sourcezone (21) umschließende Gateelektrode (30) (Fig. 5).

10. Feldeffekttransistor nach Anspruch 1, dadurch gekennzeichnet, daß die Driftstrecke eine im wesentlichen konstante Breite hat und daß sich ihre Dotierungskonzentration von der Gateelektrode zur Drainzone hin erhöht.

## Claims

1. A field effect transistor comprising a semiconductor substrate (1) of the first conductivity type, a source zone (4) and a drain zone (5) of the opposite conductivity type, a zone (8, 14) of the opposite conductivity type which is arranged between the source and drain zone and which is more weakly doped than the source and drain zone and which is surrounded by a region (2) which is of the first conductivity type and is more highly doped than the substrate (1), and a gate electrode (9, 16) which is insulated from the surface of the semiconductor substrate and which covers the said zone (8, 14) over its entire width, whereby the part of the said zone (8, 14) which is arranged between the gate electrode (9, 16) and the drain zone (5) forms a drift path for the charge carriers, characterised in that the cross-section of the drift path (8, 14) at right angles to the direction of drift, starting from the gate electrode (9, 16) and in the direction towards the drain zone (5), contains an increasing number of dopant atoms.

2. A field effect transistor according to Claim 1, characterised in that the drift path (8, 14) has an essentially constant doping and the width of the drift path increases from the gate electrode (9,16) towards the drain zone (5), to a value which equals a multiple of the width of the drain zone (5).

3. A field effect transistor according to Claim 2, characterised in that the gate electrode (9) is stripshaped and said zone (8) widens towards the drain zone (5) (Fig. 1).

4. A field effect transistor according to Claim 2, characterised in that said zone (14) has a constant width and that the gate electrode (16) is provided with a recess (26) which widens towards the drain zone (5).

5. A field effect transistor according to one of Claims 2 to 4, characterised in that the drift path (8, 14) widens in a funnel-shaped manner and that the opening angle lies between 20° and <180°.

6. A field effect transistor according to one of Claims 1 to 5, characterised by a further zone (10, 27, 31, 35) of the first conductivity type which has a doping concentration which is at least equally high as the substrate (1), which interrupts said zone and which is at least partially covered by the gate electrode (9, 16, 25, 30, 34).

7. A field effect transistor according to one of Claims 4 to 6, characterised by a plurality of source zones (32) and drain zones (22), which are respectively arranged adjacent to one another in said zone and electrically interconnected, and by a drift region (20) which is formed from the individual drift paths of the oppositely-located source and drain zones, which are located opposite to one another, and which drift region is common to all the source and drain zones, and by a common gate electrode (34) adjoining all the drift paths (Fig. 6).

8. A field effect transistor according to Claim 7, characterised by a strip-shaped source zone (21) which is common to all the drain zones (22), by a further zone (27) commen to all the drain zones (22), and by a gate electrode (25) which is provided with a plurality of recesses (26) located opposite the drain zones and which correspond in number to the number of drain zones (22) (Fig. 4).

9. A field effect transistor according to Claim 8, characterised by a further zone (31) surrounding the source zone (21) and by a gate electrode (30) surrounding the source zone (21) (Fig. 5).

10. A field effect transistor according to Claim 1, characterised in that the drift path has an essentially constant width, and that its doping concentration increases from the gate electrode to the drain zone.

**Revendications**

1. Transistor à effet de champ avec un substrat semiconducteur (1) d'un premier type de conductibilité, une zone de source (4) et une zone de drain (5) de type de conductibilités opposées, avec une zone (8, 14) du type de conductibilité opposée et située entre la zone de source et de drain, et qui est plus faiblement dopée que la zone de source et de drain et qui est entourée d'une plage (2) qui est du premier type de conductibilité et plus fortement dopée que le substrat (1), avec une électrode de grille (9, 16) isolée par rapport à la surface du substrat semiconducteur, et qui recouvre sur la totalité de sa largeur ladite zone (8, 14), la partie de ladite zone (8, 14) qui se situe entre l'électrode de grille (9, 16) et la zone de drain (5), formant une voie de glissement pour les porteurs de charges, caractérisé par le fait que la section transversale de la voie de glissement (8, 14) comporte, perpendiculairement à la direction du glissement et en partant de l'électrode de grille (9, 16) en direction de la zone de drain (5), un nombre croissant d'atomes de substance de dopage.

2. Transistor à effet de champ selon la revendication 1, caractérisé par le fait que la voie de glissement (8, 14) comporte un dopage sensiblement constant et sa largeur, en partant de l'électrode de grille (9, 16) vers la zone de drain (5), s'élargit à une valeur qui est égale à un multiple de la largeur de la zone de drain (5).

3. Transistor à effet de champ selon la revendication 2, caractérisé par le fait que l'électrode de grille (9) a la forme d'une bande et ladite zone (8) s'élargit en direction de la zone de drain (5) (figure 1).

4. Transistor à effet de champ selon la revendication 2, caractérisé par le fait que ladite zone (14) a une largeur constante et que l'électrode de grille (16) est pourvue d'une ouverture ou encoche (26) qui s'élargit en direction de la zone de drain (5).

5. Transistor à effet de champ selon l'une des revendications 2 à 4, caractérisé par le fait que la voie de glissement (8, 14) s'élargit en forme d'entonnoir et que l'angle d'ouverture se situe entre 20° et <180°.

6. Transistor à effet de champ selon l'une des revendications 1 à 5, caractérisé par une zone supplémentaire (10, 27, 31, 35) du premier type de conductibilité et à concentration de dopage au moins aussi importante que le substrat (1), ladite zone supplémentaire interrompant ladite zone et étant au moins partiellement recouverte par l'électrode de grille (9, 16, 25, 30, 34).

7. Transistor à effet de champ selon l'une des revendications 4 à 6, caractérisé par un grand nombre de zones de source (32) et de drain (22) disposées dans ladite zone situées les unes à côté des autres et reliées électriquement entre elles, par une plage de glissement (20) qui est commune à toutes les zones de source et de drain et qui est formée par les voies de glissement individuelles de zones de source et de drain qui se situent les unes en face des autres, et par une électrode de grille (34) qui avoisine toutes les voies de glissement (figure 6).

8. Transistor à effet de champ selon la revendication 7, caractérisé par une zone de source (21) en forme de bande et commune à toutes les zones de drain, par une zone supplémentaire (27) commune à toutes les zones de drain et par une électrode de grille (25) qui est porvue d'un nombre d'ouvertures ou d'encoches (26) situées en face des zones de drain et qui correspond au nombre des zones de drain (22).

9. Transistor à effet de champ selon la revendication 8, caractérisé par une zone supplémentaire (31) entourant la zone de source (21) et par une électrode de grille (30) entourant la zone de source (21) (figure 5).

10. Transistor à effet de champ selon la revendication 1, caractérisé par le fait que la voie de glissement possède une largeur sensiblement constante et que sa concentration en dopage augmente de l'électrode de grille vers la zone de drain.

## FIG 1

## FIG 2

## FIG 3

## FIG 4

## FIG 5

## FIG 6